# EUROPEAN PATENT APPLICATION

(11) **EP 4 440 256 A1**
(43) Date of publication of application: **02.10.2024**
(21) Application number: 24154025.1
(22) Date of filing: 25.01.2024
(51) Int. Cl.: H05K 5/03, H05K 5/00

(54) **DEVICE MOUNTING PANEL AND CONTROL APPARATUS**

(30) Priority: 28.03.2023 JP 2023051408
(71) Applicant: BROTHER KOGYO KABUSHIKI KAISHA, Nagoya-shi, Aichi 467-8561 (JP)
(72) Inventor: KUMAGAI, Yosuke, Nagoya, 467-8562 (JP)
(74) Representative: Prüfer & Partner mbB Patentanwälte · Rechtsanwälte

(57) **Abstract**

A pane 20 includes a metal plate 60 in which a plurality of device mounting holes are formed, and a portion of the metal plate 60 is configured to be removable as the removable lid 62 in at least one of the plurality of device mounting holes 61. The metal plate 60 includes a slit 63 by which the removable lid 62 is isolated from an edge 61A of the device mounting hole 61, a first breakable portion 64A and a second breakable portion 64B configured to connect the removable lid 62 to the edge 61A of the device mounting hole 61 at the middle of the slit 63 and allowing the removable lid 62 to be removed from the device mounting hole 61 by pressing the removable lid 62 as needed, and a first screw hole 65A, a second screw hole 65B, a third screw hole 65C and a fourth screw hole 65D each formed at a position outside the edge 61A of the device mounting hole 61 on the metal plate 60 and an edge of each of the first screw hole 65A, the second screw hole 65B, the third screw hole 65C and the fourth screw hole 65D is formed at a position within the distance equal to or less than twice a thickness of the metal plate 60 from the edge 61A of the device mounting hole 61.

## Description

### BACKGROUND

This disclosure relates to a device mounting panel to which various kinds of devices are mounted and a control apparatus including the device mounting panel.

Patent Document 1 (Japanese Patent Application Publication No. 2004-253591) discloses a device mounting panel in which a portion of a panel plate is configured to be removable by the user by pressing or punching with a hammer as a removable lid in a device mounting hole formed in the panel plate, the removable lid is isolated from an edge of the device mounting hole by a slit, and a breakable portion configured to connect the removable lid to the edge of the device mounting hole is formed at the middle of the slit and allowing the removable lid to be removed from the device mounting hole by pressing the removable lid as needed when being broken.

### SUMMARY

Incidentally, in a case where a connector to which, for example, an electric device is mounted is mounted in the device mounting hole, it is considered that the connector is fixed to the panel plate in a state in which a plurality of screws are respectively screwed in a plurality of screw holes formed at positions close to the device mounting hole and a plurality of screw holes formed on a connector side. The larger a distance between the device mounting hole and the plurality of screw holes formed close to the device mounting hole, the more necessary it is to use the connector having a larger footprint. Accordingly, it is preferable that the distance between the device mounting hole and the plurality of screw holes formed close to the device mounting hole is small.

In the device mounting panel disclosed in Patent Document 1, however, there is no description that how the electric device is mounted in the device mounting hole. Accordingly, the relationships between the device mounting hole and the plurality of screw holes are not clear.

The present disclosure provides a device mounting panel and a control apparatus including the device mounting panel in which relationships between a device mounting hole and a plurality of screw holes formed close to the device mounting hole are designated.

One aspect of the disclosure relates to a device mounting panel including a metal plate in which a plurality of device mounting holes are formed, a portion of the metal plate being configured to be removable, as a removable lid, in at least one of the plurality of device mounting holes. The metal plate includes a slit by which the removable lid is isolated from an edge of the at least one of the plurality of device mounting holes, at least one breakable portion continuously extending from the edge of the at least one of the plurality of device mounting holes to the removable lid and allowing the removable lid to be removed from the at least one of the plurality of device mounting holes when being broken, and at least one screw hole formed at a position outside the edge of the at least one of the plurality of device mounting holes on the metal plate, an edge of the at least one screw hole being formed at a position within a distance equal to or less than twice a thickness of the metal plate from the edge of the at least one of the plurality of device mounting holes.

Another aspect of the disclosure relates to a control apparatus including an outer housing including an opening formed on one side surface of the outer housing, the one side surface being intersecting a placement surface of the control apparatus, an inner housing accommodated in the outer housing so as to be drawable from the outer housing through the opening, and the device mounting panel. The device mounting panel having a shape capable of covering the opening is drawable from the outer housing together with the inner housing. The panel is disposed in front of the inner housing in a drawing direction.

According to the configurations as described above, it is possible to provide the device mounting panel and the control apparatus including the device mounting panel in which relationships between the device mounting hole and the plurality of screw holes formed close to the device mounting hole are designated.

### BRIEF DESCRIPTION OF DRAWINGS

The objects, features, advantages, and technical and industrial significance of the present disclosure will be better understood by reading the following detailed description of the embodiment, when considered in connection with the accompanying drawings, in which:
Fig. 1 is a perspective view illustrating an external appearance of a control apparatus of the present disclosure;
Fig. 2 is a view illustrating a state in which an inner housing of the control apparatus illustrated in in FIG. 1 is drawn out;
FIG. 3 is a partial enlarged perspective view illustrating a structure close to the device mounting hole formed in a metal plate of a panel of the control apparatus illustrated in Fig. 1;
FIG. 4 is a view illustrating an example of relationships between the device mounting hole and a plurality of screw holes;
FIG. 5 is a partial enlarged perspective view illustrating a structure close to the device mounting hole in a state in which a sticky sheet is stuck on a surface of the metal plate of the panel of the control apparatus illustrated in FIG. 1;
FIG. 6A is a view illustrating a state before a connector is mounted in the device mounting hole;
FIG. 6B is a view illustrating the state before the connector is mounted in the device mounting hole;
FIG. 6C is a view illustrating the state before the connector is mounted in the device mounting hole;
FIG.6D is a view illustrating a state after the connector has been mounted in the device mounting hole; and
FIG. 7 is a perspective view illustrating an external appearance of the control apparatus illustrated in FIG. 1 in which connectors have been respectively mounted in device mounting holes formed in the metal plate of the panel of the control apparatus.

### EMBODIMENTS

There will be described below an embodiment of the present disclosure in details with reference to drawings. In the drawings used by the following description, it may be dispensed with to draw a part of a main configuration, and the ratio among the drawn parts and the like are not necessarily accurate. In each of the drawings, a front and rear direction D1, an up and down direction D2 and a right and left direction D3 indicate corresponding directions illustrated in each of the drawings.

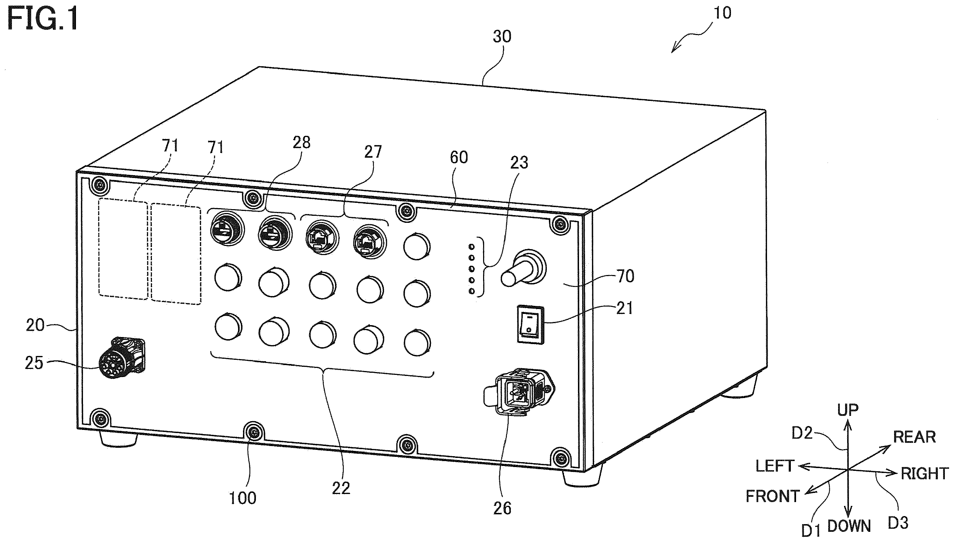

Fig. 1 illustrates an external appearance of a control apparatus 10 of a first embodiment of the present disclosure. The control apparatus 10 controls an external device. In the present embodiment, a laser head as the external device, not illustrated, having a laser emitter is connected to the control apparatus 10. The control apparatus 10 is configured to execute a marking process in which a two-dimensional scanning is performed on a processing surface of an object to be processed by controlling the laser head.

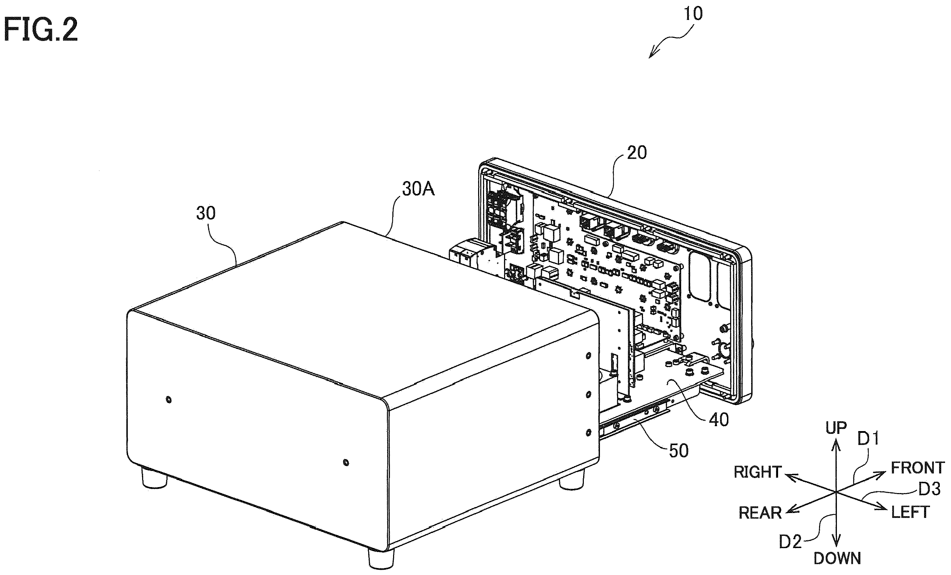

As illustrated in Fig. 1, the control apparatus 10 includes an outer housing 30 which is shaped like a box and has an opening 30A on a front face thereof (see Fig. 2), and a panel 20 configured to cover the opening 30A. And, the panel 20 is screwed and fixed to the outer housing 30 by a plurality of screws 100. On the panel 20, a power switch 21, various kinds of connectors 22, a plurality of indicators 23 consisted of a plurality of LEDs (Light Emitting Diode), a terminal 25 to which a cable, not illustrated, connecting the laser head with the control apparatus 10 is connected, a terminal 26 to which a power cable, not illustrated, for supplying commercial power (for example, 100V) is connected, terminals 27 to which LAN (Local Area Network) cables, not illustrated, are connected, terminals 28 to which USB (Universal Serial Bus) cables, not illustrated, are connected, and the like are provided. That is, the panel 20 has a function of an operational panel.

As illustrated in Fig. 2, the panel 20 is configured so that the panel 20 can be drawn out frontward in a state in which the plurality of screws 100 are removed. An inner housing 40 is connected to a back side of the panel 20, and the inner housing 40 is disposed on a pair of rails 50 including a left-side rail 50 and a right-side rail 50. It is noted that the right-side rail 50 is not illustrated in Fig. 2. Accordingly, when the panel 20 is drawn out frontward, the inner housing 40 is drawn from an inside of the outer housing 30 via the pair of rails 50.

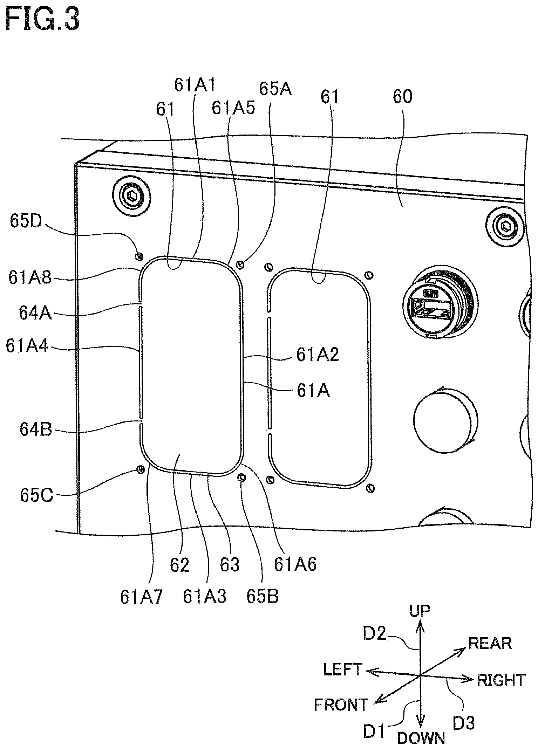

As illustrated in Fig. 1, the panel 20 includes a metal plate 60 in which a plurality of device mounting holes are formed and a sticky sheet 70 stuck to and covering an entire surface of the metal plate 60. The plurality of device mounting holes includes two device mounting holes 61, 61, in which additional electric devices are mounted or installed (see Fig. 3), in addition to device mounting holes, having no reference numbers, in which the power switch 21, the various types of connectors 22, the indicator 23 and the terminals 25 - 28 are mounted.

Fig. 3 illustrates a structure around the two device mounting holes 61, 61 of the metal plate 60 in a state in which the sticky sheet 70 is not stuck to the metal plate 60. As illustrated in Fig. 3, the two device mounting holes 61, 61 is formed so as to be arranged in the right and left direction D3 on the metal plate 60. It is noted that each of the two device mounting holes 61, 61 has the same configuration, so there will be explained the left side device mounting hole 61 below on behalf of the two device mounting holes 61, 61.

The device mounting hole 61 is defined by an edge 61A including four straight portions, that is, a first straight portion 61A1, a second straight portion 61A2, a third straight portion 61A3 and a fourth straight portion 61A4, and four curved portions each connecting two of the straight portions adjacent to each other, that is, a first curved portion 61A5, a second curved portion 61A6, a third curved portion 61A7 and a fourth curved portion 61A8. The device mounting hole 61 has a substantially rectangular shape defined by the first straight portion 61A1, the second straight portion 61A2, the third straight portion 61A3, the fourth straight portion 61A4, the first curved portion 61A5, the second curved portion 61A6, the third curved portion 61A7 and the fourth curved portion 61A8.

A removable lid 62 which is a portion of the metal plate 60 is left in the device mounting hole 61, and the removable lid 62 is isolated from the device mounting hole 61 by a slit 63. And, in the slit 63, a first breakable portion 64A is formed at a position between the fourth straight portion 61A4 and the fourth curved portion 61A8 adjacent upward to the fourth straight portion 61A4. The first breakable portion 64Ais configured to connect the removable lid 62 to the edge 61A of the device mounting hole 61, that is, the first breakable portion 64A continuously extends from the edge 61A of the device mounting hole 61 to the removable lid 62. Similarly, in the slit 63, a second breakable portion 64B is formed at a position between the fourth straight portion 61A4 and the third curved portion 61A7 adjacent downward to the fourth straight portion 61A4. The second breakable portion 64B is configured to connect the removable lid 62 to the edge 61A of the device mounting hole 61, that is, the second breakable portion 64B continuously extends from the edge 61A of the device mounting hole 61 to the removable lid 62.

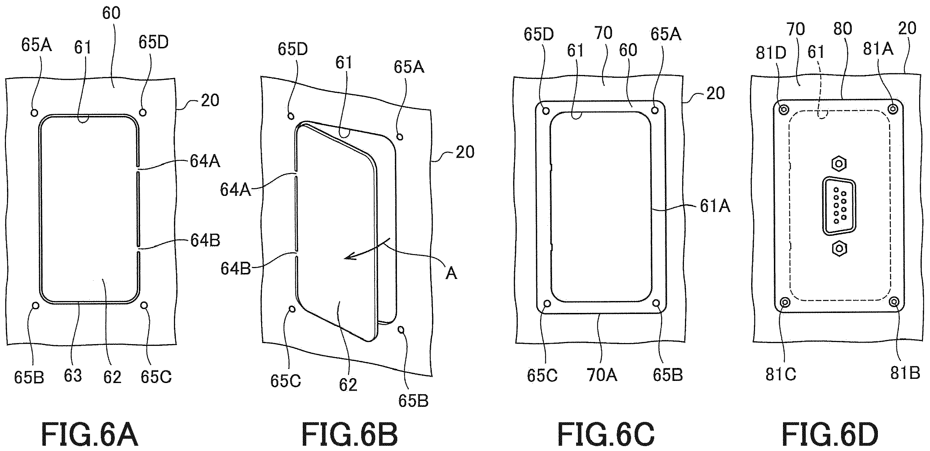

As described above, the first breakable portion 64A and the second breakable portion 64B are respectively formed at upper end part and a lower end part of the fourth straight portion 61A4 defining the device mounting hole 61, however, the first breakable portion 64A and the second breakable portion 64B may be formed at both end parts of any one of the first straight portion 61A1, the second straight portion 61A2 and the third straight portion 61A3 other than the fourth straight portion 61A4. Moreover, the number of the breakable portions is not limited to two. The number of the breakable portions may be one, or three or more. It is noted that, there will be described below by using Figs. 6A-6D, since the breakable portion is broken by pushing the removable lid 62 when the removable lid 62 is removed from the device mounting hole 61, it is preferable that the number of the breakable portions and/or the width of the breakable portion are determined such that the breakable portion is easily broken by a large pressing force and the breakable portion is not easily broken by a small pressing force.

A first screw hole 65A, a second screw hole 65B, a third screw hole 65C and a fourth screw hole 65D are respectively formed at four corners of the device mounting hole 61. The first screw hole 65A, the second screw hole 65B, the third screw hole 65C and the fourth screw hole 65D are used when a connector is mounted in the device mounting hole 61 after the removable lid 62 is removed from the metal plate 60. It is noted that in a case where a thickness of the metal plate 60 falls within a range, for example, from 0.8 mm to 1.5 mm, it is necessary for the first screw hole 65A, the second screw hole 65B, the third screw hole 65C and the fourth screw hole 65D to be respectively formed as burring holes. In contrast, in a case where the thickness of the metal plate 60 is small and the first screw hole 65A, the second screw hole 65B, the third screw hole 65C and the fourth screw hole 65D are not the burring holes, it is difficult to screw screws in the screw holes 65A -65D in tight.

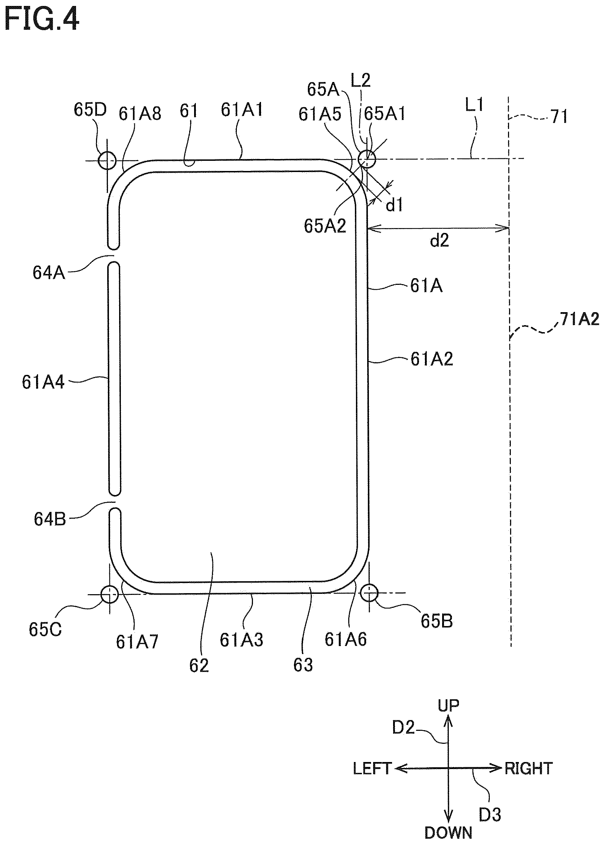

Fig. 4 illustrates an example of relationships between the device mounting hole 61 and the first screw hole 65A, the second screw hole 65B, the third screw hole 65C and the fourth screw hole 65D. In the example illustrated in Fig. 4, the relationships between the edge 61A of the device mounting hole 61 and each of the first screw hole 65A, the second screw hole 65B, the third screw hole 65C and the fourth screw hole 65D are the same as each other. Accordingly, there will be explained the relationship between the edge 61A of the device mounting hole 61 and the first screw hole 65A below on behalf of the relationships between the edge 61A of the device mounting hole 61 and each of the four screw holes 65A - 65D.

As illustrated in Fig. 4, a center 65A1 of the first screw hole 65A is located on a point of intersection of a first straight line L1 that is an extension line, extended rightward, of the first straight portion 61A1 defining the device mounting hole 61 and a second straight line L2 that is an extension line, extended upward, of the second straight portion 61A2 defining the device mounting hole 61. That is, the first screw hole 65A is formed such that the center 65A1 of the first screw hole 65A is located on the point of intersection of the first straight line L1 and the second straight line L2. Further, the first screw hole 65A is formed such that a distance d1 between an edge 65A2 of the first screw hole 65A and the edge 61A of the device mounting hole 61 is equal to or less than twice the thickness of the metal plate 60. The reason why the position where the first screw hole 65A is formed is designated is that a size of the connector to be mounted in the device mounting hole 61 is reduced as much as possible. It is noted that the first screw hole 65A may be formed such that the center 65A1 is located at a position outside the point of intersection of the first straight line L1 and the second straight line L2 as long as the distance d1 is equal to or less than twice the thickness of the metal plate 60. It is noted that, as in the present embodiment, in a case where the first screw hole 65A is formed as the burring hole, the edge 65A2 of the first screw hole 65A corresponds to an edge portion which is an outer side portion of a convex portion (a flange) formed by a burring process.

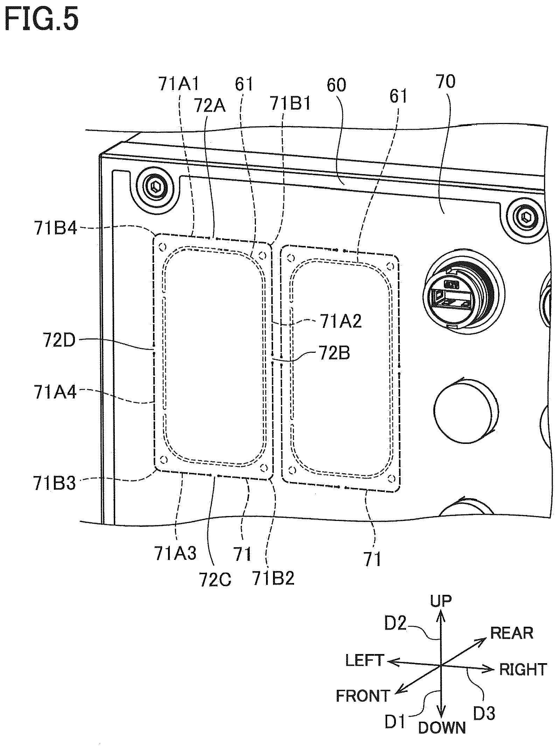

Fig. 5 illustrates a structure around the two device mounting holes 61, 61 of the metal plate 60 on which the sticky sheet 70 is stuck. As illustrated in Fig. 5, two cutting lines 71, 71 are formed on the sticky sheet 70 such that the two device mounting holes 61, 61 and two sets of the four screw holes 65A-65D are respectively surrounded by the two cutting lines 71, 71. Since each of the two cutting lines 71, 71 has the same configuration, there will be explained the left side the cutting line 71 below on behalf of the two cutting lines 71, 71.

The cutting line 71 has a substantially rectangular shape similar to the device mounting hole 61, and the cutting line 71 includes four straight portions, that is, a first straight portion 71A1, a second straight portion 71A2, a third straight portion 71A3 and a fourth straight portion 71A4, and four curved portions each connecting two of the four straight portions adjacent to each other, that is, a first curved portion 71B 1, a second curved portion 71B2, a third curved portion 71B3 and a fourth curved portion 71B4. And, a first connecting point 72A, a second connecting point 72B, a third connecting point 72C and a fourth connecting point 72D are respectively formed at substantially central positions of the first straight portion 71A1, the second straight portion 71A2, the third straight portion 71A3 and the fourth straight portion 71A4. Perforation is formed at a portion of each of the first straight portion 71A1, the second straight portion 71A2, the third straight portion 71A3 and the fourth straight portion 71A4 except for the first connecting point 72A, the second connecting point 72B, the third connecting point 72C and the fourth connecting point 72D. Perforation is formed at each of the first curved portion 71B1, the second curved portion 71B2, the third curved portion 71B3 and the fourth curved portion 71B4. As there will be described below by using Figs. 6A-6D, when the removable lid 62 is removed from the device mounting hole 61, a portion of the sticky sheet 70 located inside the cutting line 71 is also removed from the sticky sheet 70 together with the removable lid 62. The reason why the perforation is formed as described above is that the perforation allows the portion of the cutting line 71 located inside the cutting line 71 to be easily removed from the sticky sheet 70. Accordingly, the cutting line 71 is not limited to the perforation as long as the portion of the sticky sheet 70 can be easily removed from the sticky sheet 70 by the cutting line 71. Other cutting manners such as a manner of a half cut may be applicable.

An example of a positional relationship between the first screw hole 65A and the cutting line 71 is also illustrated in Fig. 4. As described above, in the case where the thickness of the metal plate 60 falls within a range, for example, from 0.8 mm to 1.5 mm, it is necessary for the first screw hole 65A, the second screw hole 65B, the third screw hole 65C and the fourth screw hole 65D to be respectively formed as burring holes. It is noted that in the case where the first screw hole 65A, the second screw hole 65B, the third screw hole 65C and the fourth screw hole 65D are burring holes, a slightly hollow surface occurs at a periphery of each of the first screw hole 65A, the second screw hole 65B, the third screw hole 65C and the fourth screw hole 65D. It is noted that degrees of the hollow surfaces of the first screw hole 65A, the second screw hole 65B, the third screw hole 65C and the fourth screw hole 65D are the same as each other, so there will be explained the first screw hole 65A below on behalf of the first screw hole 65A, the second screw hole 65B, the third screw hole 65C and the fourth screw hole 65D.

In a case where the cutting line 71 is located at the edge of the first screw hole 65A in a state in which the slightly hollow surface has occurred at the periphery of the first screw hole 65A, a space occurs between the cutting line 71 and the hollow surface at the periphery of the first screw hole 65A, and adhesiveness of the sticky sheet 70 to the metal plate 60 becomes small. As a result of this, there is a possibility that dustproof property and waterproof property through the first screw hole 65A, the second screw hole 65B, the third screw hole 65C and the fourth screw hole 65D into the inside of the control apparatus 10 drop. In order to deal with this, a position of the cutting line 71 is determined such that a distance d2 between the center 65A1 of the first screw hole 65A and the cutting line 71 falls within a range from 2.5 mm to 5.0 mm. More specifically, the cutting line 71 is formed such that the distance d2 between a straight portion of the cutting line 71 and the center of each of the first screw hole 65A, the second screw hole 65B, the third screw hole 65C and the fourth screw hole 65D in a direction orthogonal to the straight portion of the cutting line 71 falls within a range from 2.5 mm to 5.0 mm.

There will be described below, with reference to Figs. 6A - 6D, a method of mounting the connector 80 into the device mounting hole 61 from which the removable lid 62 has been removed configured as above described.

Fig. 6A illustrates a state of the device mounting hole 61, viewed from an inside of the panel 20, before the removable lid 62 is removed. In a case where a user removes the removable lid 62 in this state, the user presses the removable lid 62 from the inside of the panel 20.

Fig. 6B illustrates a state of the removable lid 62, when viewed from an outside of the panel 20, in which the removable lid 62 is pushed. As illustrated in Fig. 6B, when the removable lid 62 is pushed, the removable lid 62 pivots in a direction of an arrow A about an axis passing through the first breakable portion 64A and the second breakable portion 64B. And then, after the user repeatedly pivots the removable lid 62 in the direction of the arrow A and in a direction opposite to the direction of the arrow A, the first breakable portion 64A and the second breakable portion 64B are broken and the removable lid 62 is removed from the device mounting hole 61.

Fig. 6C illustrates a state of the device mounting hole 61, viewed from the outside of the panel 20, after the removable lid 62 has been removed. As illustrated in Fig. 6C, when the removable lid 62 is removed, a portion of the sticky sheet 70 surrounding the removable lid 62 is removed together with the removable lid 62 from the sticky sheet 70 by the cutting line 71, so a portion of the metal plate 60, surrounding the device mounting hole 61 and located between the edge 61A of the device mounting hole 61 and an edge 70A of the sticky sheet 70, exposes. It is noted that, as a matter of convenience in illustrating, a state in which the portion of the sticky sheet 70 surrounding the removable lid 62 is removed from the sticky sheet 70 by the cutting line 71 is not illustrated in Fig. 6B.

Fig. 6D illustrates a state in which a connector 80 is mounted in the device mounting hole 61 after the removable lid 62 has been removed. As illustrated in Fig. 6D, the connector 80 is mounted on the panel 20 by four screws, that is, a screw 81A, a screw 81B, a screw 81C and a screw 81D.

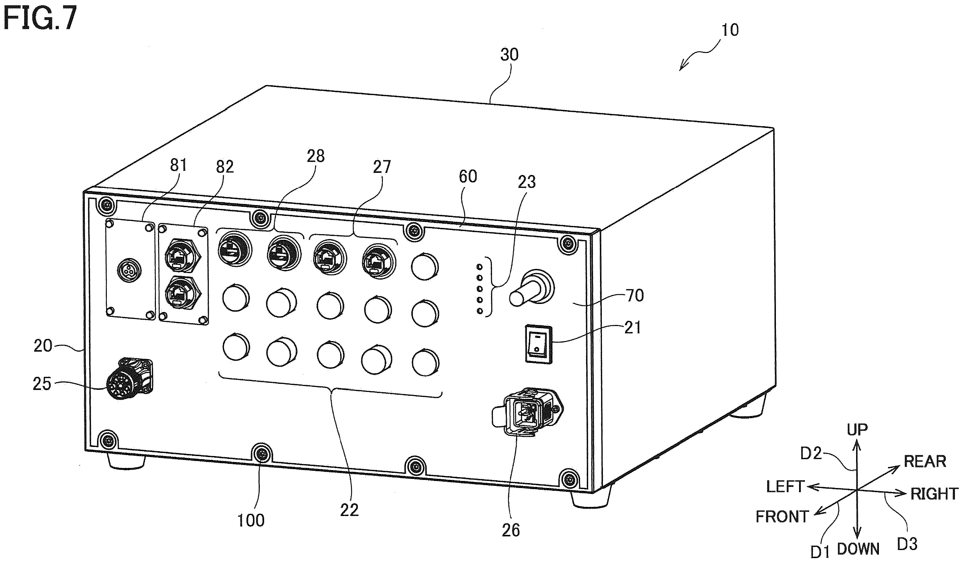

Fig. 7 illustrates a state in which a connector 81 and a connector 82 are respectively mounted into the two device mounting holes 61, 61 in accordance with steps explained by using Figs. 6A - 6D. It is noted that it is not necessary to mount the two connectors 81, 82 into the two device mounting holes 61, 61. The connector 81 may be mounted into only one of the two device mounting hole 61, 61, for example, only the left side device mounting hole 61, and the connector 82 may not be mounted into the right side device mounting hole 61. In this case, the right side device mounting hole 61 may be covered with the sticky sheet 70 in which the sticky sheet 70 having the cutting line 71 is stuck on the metal panel 60.

As described above, the panel 20 in the present embodiment includes the metal plate 60 in which the plurality of device mounting holes are formed, and the portion of the metal plate 60 is configured to be removable as the removable lid 62 in at least one of the plurality of device mounting holes 61. The metal plate 60 includes the slit 63 by which the removable lid 62 is isolated from the edge 61A of the device mounting hole 61, the first breakable portion 64A and the second breakable portion 64B each configured to connect the removable lid 62 to the edge 61A of the device mounting hole 61, formed at the middle of the slit 63 and allowing the removable lid 62 to be removed from the device mounting hole 61 by pressing the removable lid 62 as needed, and the first screw hole 65A, the second screw hole 65B, the third screw hole 65C and the fourth screw hole 65D each formed at the position outside the edge 61A of the device mounting hole 61 on the metal plate 60 and the edge of each of the first screw hole 65A, the second screw hole 65B, the third screw hole 65C and the fourth screw hole 65D is formed at the position within the distance equal to or less than twice the thickness of the metal plate 60 from the edge of the at least one of the plurality of device mounting holes.

As described above, in the panel 20 of the present embodiment, since the metal plate 60 includes the first screw hole 65A, the second screw hole 65B, the third screw hole 65C and the fourth screw hole 65D in which the edge of each of the screw holes is formed at the position within the distance equal to or less than twice the thickness of the metal plate 60 from the edge 61A of the device mounting hole 61, it is possible to determine the positional relationships between the device mounting hole 61 and each of the first screw hole 65A, the second screw hole 65B, the third screw hole 65C and the fourth screw hole 65D each formed at the position close to the device mounting hole 61.

Moreover, the sticky sheet 70 configured to cover the slit 63 and the first screw hole 65A, the second screw hole 65B, the third screw hole 65C and the fourth screw hole 65D is stuck on the metal plate 60, and any one of the half cut portion, the perforation and the cutting line 71, each having the circular shape, configured to define the inside section of the metal plate 60 in which the slit 63, the first screw hole 65A, the second screw hole 65B, the third screw hole 65C and the fourth screw hole 65D are located is formed in the sticky sheet 70.

As described above, since the slit 63, the first screw hole 65A, the second screw hole 65B, the third screw hole 65C and the fourth screw hole 65D are covered with the sticky sheet 70, it is possible to reduce the entrance of dust, mist and so on into the control apparatus 10 through the slit 63, the first screw hole 65A, the second screw hole 65B, the third screw hole 65C and the fourth screw hole 65D.

Moreover, in the case where the thickness of the metal plate 60 falls within the range from 0.8 mm to 1.5 mm, the one of the half cut portion, the perforation and the cutting line 71, each having the circular shape, of the sticky sheet 70 is formed at the position ranging from 2.5 mm to 5.0 mm outwardly from the center 65A1 of each of the first screw hole 65A, the second screw hole 65B, the third screw hole 65C and the fourth screw hole 65D.

As described above, in the case where the thickness of the metal plate 60 falls within the range from 0.8 to 1.5 mm, it is necessary for the first screw hole 65A, the second screw hole 65B, the third screw hole 65C and the fourth screw hole 65D to be respectively formed as the burring holes, so the slightly hollow surface occurs at the periphery of each of the first screw hole 65A, the second screw hole 65B, the third screw hole 65C and the fourth screw hole 65D. Accordingly, the circular one of the half cut portion, the perforation and the cutting line 71 of the sticky sheet 70 is formed at the position ranging from 2.5 mm to 5.0 mm outwardly from the center of each of the first screw hole 65A, the second screw hole 65B, the third screw hole 65C and the fourth screw hole 65D. As a result of this, the adhesive property between the sticky sheet 70 and the metal plate 60 increases and dustproof property and water proof property regarding the entrance of dust and mist into the control apparatus 10 through the first screw hole 65A, the second screw hole 65B, the third screw hole 65C and the fourth screw hole 65D are improved.

Moreover, the device mounting hole 61 having the substantially rectangular shape includes the edge 61A consisted of the four straight portions, that is, the first straight portion 61A1, the second straight portion 61A2, the third straight portion 61A3 and the fourth straight portion 61A4, and the four curved portions each connecting two of the four straight portions adjacent to each other, that is, the first curved portion 61A5, the second curved portion 61A6, the third curved portion 61A7 and the fourth curved portion 61A8. The center of each of the first screw hole 65A, the second screw hole 65B, the third screw hole 65C and the fourth screw hole 65D is located on the line of the rectangle defined by four apexes each as the point of intersection of the two extension lines of two of the four straight portions, that is, the first straight portion 61A1, the second straight portion 61A2, the third straight portion 61A3 and the fourth straight portion 61A4 adjacent to each other or located on outside the rectangle.

According to this, it is possible to reduce the size of the connector to be mounted into the device mounting hole 61 as much as possible.

Moreover, the device mounting hole 61 having the substantially rectangular shape includes the edge 61A consisted of the four straight portions, that is, the first straight portion 61A1, the second straight portion 61A2, the third straight portion 61A3 and the fourth straight portion 61A4, and the four curved portions each connecting two of the first straight portion 61A1, the second straight portion 61A2, the third straight portion 61A3 and the fourth straight portion 61A4 adjacent to each other, that is, the first curved portion 61A5, the second curved portion 61A6, the third curved portion 61A7 and the fourth curved portion 61A8. The first breakable portion 64A and the second breakable portion 64B are located at only one straight portion, that is, the fourth straight portion 61A4 of one of the four straight portion, that is, the first straight portion 61A1 of the first straight portion 61A1, the second straight portion 61A2, the third straight portion 61A3 and the fourth straight portion 61A4.

As a result of this, when the user removes the removable lid 62 from the device mounting hole 61, the user can break the first breakable portion 64A and the second breakable portion 64B without applying much pressing force. Accordingly, it is possible to easily remove the removable lid 62 from the device mounting hole 61.

The control apparatus 10 of the present embodiment includes the outer housing 30 including the opening 30A formed on the one side surface, intersecting the placement surface of the control apparatus 10, of the outer housing 30, the inner housing 40 accommodated in the outer housing 30 so as to be drawable from the outer housing 30 through the opening 30A, and the panel 20. The panel 20 having the shape capable of covering the opening 30A is drawable from the outer housing 30 together with the inner housing 40 and the panel 20 is disposed in front of the inner housing 40 in a drawing direction.

According to this, it is possible to achieve the control apparatus 10 including the panel 20 having the above described features.

While the embodiments have been described above, it is to be understood that the disclosure is not limited to the details of the illustrated embodiments, but may be embodied with various changes and modifications, which may occur to those skilled in the art, without departing from the spirit and scope of the disclosure.

In the above described embodiment, the number of the device mounting holes 61 into which the additional electric devices are mounted is two, however, the number of the device mounting holes 61 is not limited to two. The number of the device mounting holes 61 may be one, or three or more. Moreover, the shape of the device mounting hole 61 is not limited to the substantially rectangular shape. The shape of the device mounting holes 61 may be a circular shape, an ellipse shape, or other shapes.

In the above described embodiment, the laser head is used as the external device to be controlled, however, the external device is not limited to the laser head.

In the above described embodiment, the LED is used as the indicator 23, however, the indicator 23 is not limited to the LED. The indicator 23 may be, for example, a LED display and characters and figures may be displayed on the LED display.

In the above described embodiment, the switches, the indicator, and the various kinds of connecting terminals are provided on the panel 20, however, any one of the switches, the indicator, and the various kinds of connecting terminals may be dispensed with, and none of the switches, the indicator, and the various kinds of connecting terminals may be provided on the panel 20.

## Claims

1. A device mounting panel (20), comprising:
a metal plate (60) in which a plurality of device mounting holes (61) are formed, a portion of the metal plate being configured to be removable, as a removable lid (62), in at least one of the plurality of device mounting holes (61),
wherein the metal plate (60) includes:
a slit (63) by which the removable lid (62) is isolated from an edge (61A) of the at least one of the plurality of device mounting holes (61),
at least one breakable portion (64A, 64B) continuously extending from the edge (61A) of the at least one of the plurality of device mounting holes (61) to the removable lid (62) and allowing the removable lid (62) to be removed from the at least one of the plurality of device mounting holes (61) when being broken, and
at least one screw hole (65A, 65B, 65C, 65D) formed at a position outside the edge (61A) of the at least one of the plurality of device mounting holes (61) on the metal plate (60), an edge (65A1) of the at least one screw hole (65A, 65B, 65C, 65D) being formed at a position within a distance equal to or less than twice a thickness of the metal plate (60) from the edge (61A) of the at least one of the plurality of device mounting holes (60).

2. The device mounting panel (20) according to claim 1,
wherein a sticky sheet (70) configured to cover the slit (63) and the at least one screw hole (65A, 65B, 65C, 65D) is stuck on a surface of the metal plate (60), and
wherein one of a half cut portion, a perforation or a cutting line (71), each having a circular shape, configured to define an inside section of the metal plate (60) in which the slit (63) and the at least one screw hole (65A, 65B, 65C, 65D) are located is formed in the sticky sheet (70).

3. The device mounting panel (20) according to claim 2,
wherein, in a case where the thickness of the metal plate (60) falls within a range from 0.8 mm to 1.5 mm, the one of the half cut portion, the perforation or the cutting line (71), each having the circular shape, of the sticky sheet (70) is formed at a position ranging from 2.5 mm to 5.0 mm outwardly from a center (65A1) of the at least one screw hole (65A, 65B, 65C, 65D).

4. The device mounting panel (20) according to any one of claims 1 through 3,
wherein the at least one of the plurality of device mounting holes (61), each having a substantially rectangular shape, includes the edge consisted of four straight portions (61A1, 61A2, 61A3, 61A4) and four curved portions (61A5, 61A6, 61A7, 61A8) each connecting two of the four straight portions (61A1, 61A2, 61A3, 61A4) adjacent to each other, and
wherein a center (65A1) of the at least one screw hole (65A, 65B, 65C, 65D) is located on a line of a rectangle defined by four apexes each as a point of intersection of two extension lines of two of the four straight portion (61A1, 61A2, 61A3, 61A4) adjacent to each other, or located on outside the rectangle.

5. The device mounting panel (20) according to any one of claims 1 through 3,
wherein the at least one of the plurality of device mounting holes (61), each having a substantially rectangular shape, includes the edge consisted of four straight portions (61A1, 61A2, 61A3, 61A4) and four curved portions (61A5, 61A6, 61A7, 61A8) each connecting two of the four straight portion (61A1, 61A2, 61A3, 61A4) adjacent to each other, and
wherein the at least one breakable portion (64A, 64B) is located at only one straight portion (61A4) of the four straight portions (61A1, 61A2, 61A3, 61A4).

6. The device mounting panel according to any one of claims 1 through 3,
wherein the at least one breakable portion (64A, 64B) is located at the middle of the slit (63).

7. The device mounting panel according to any one of claims 1 through 3,
wherein the at least one breakable portion (64A, 64B) is broken when the removable lid (62) is pushed.

8. The device mounting panel according to any one of claims 1 through 3,
wherein the at least one breakable portion (64A, 64B) is configured to keep the removable lid (62) in the at least one of the plurality of device mounting holes (61) before being broken.

9. The device mounting panel (20) according to any one of claims 1 through 3,
wherein a center (65A1) of the at least one screw hole (65A, 65B, 65C, 65D) is located on a line of a rectangle defined by four extension lines (L1, L2) of the four straight portion (61A1, 61A2, 61A3, 61A4), or located on outside the rectangle.

10. A control apparatus (10), comprising:
an outer housing (30) including an opening (30A) formed on one side surface of the outer housing (30), the one side surface being intersecting a placement surface of the control apparatus (10);
an inner housing (40) accommodated in the outer housing (30) so as to be drawable from the outer housing (30) through the opening (30A); and
the device mounting panel according to any one of claims 1 through 9,
wherein the device mounting panel (20) having a shape capable of covering the opening (30A) is drawable from the outer housing (30) together with the inner housing (40), the panel (20) being disposed in front of the inner housing (40) in a drawing direction.
